# EUROPEAN PATENT SPECIFICATION

(11) **EP 2 811 530 B1**
(45) Date of publication and mention of the grant of the patent: **09.10.2019**
(21) Application number: 13170432.2
(22) Date of filing: 04.06.2013
(51) Int. Cl.: H01L 29/788, G11C 16/04, H01L 27/11558

(54) **SINGLE-POLY FLOATING-GATE TRANSISTOR COMPRISING AN ERASE GATE FORMED IN THE SUBSTRATE**
SINGLE-POLY-FLOATING-GATE-TRANSISTOR MIT EINEM IM SUBSTRAT AUSGEBILDETEN LÖSCHGATE
TRANSISTOR À GRILLE FLOTTANTE DU TYPE SINGLE-POLY COMPRENANT UNE GRILLE D'EFFACEMENT FORMÉE DANS LE SUBSTRAT

(43) Date of publication of application: 10.12.2014
(73) Proprietor: eMemory Technology Inc., Hsin-Chu 30075 (TW)
(72) Inventor: Chen, Wei-Ren, 900 Pingtung County (TW); Hsu, Te-Hsun, 310 Hsinchu County (TW); Lee, Wen-Hao, 302 Hsinchu County (TW)
(74) Representative: Krauns, Christian

(56) References cited:
- US-A1- 2010 149 874
- US-A1- 2010 157 669
- US-A1- 2012 056 257

## Description

### FIELD OF THE INVENTION

The present invention relates to a nonvolatile memory, and more particularly to an erasable programmable single-poly nonvolatile memory.

### BACKGROUND OF THE INVENTION

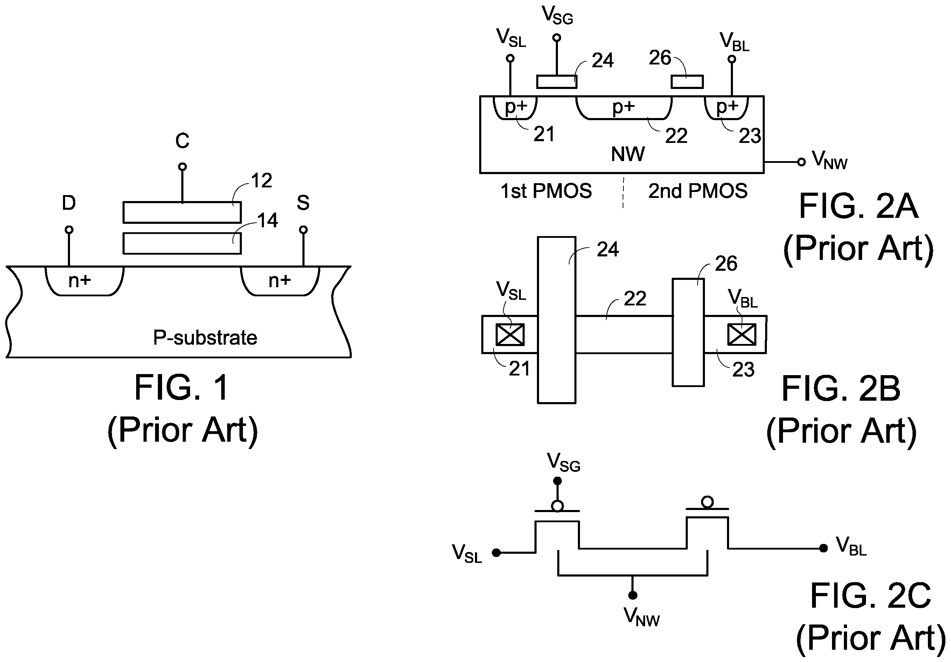

FIG. 1 is a schematic cross-sectional view illustrating a conventional programmable dual-poly nonvolatile memory. The programmable dual-poly nonvolatile memory is also referred as a floating-gate transistor. As shown in FIG. 1, this nonvolatile memory comprises two stacked and separated gates. The upper gate is a control gate 12, which is connected to a control line C. The lower gate is a floating gate 14. In addition, an n-type doped source region and an n-type doped drain region are constructed in a P-substrate. The n-type doped source region is connected to a source line S. The n-type doped drain region is connected to a drain line D.

In a case that the nonvolatile memory is in a programmed state, a high voltage (e.g. +16V) is provided by the drain line D, a ground voltage is provided by the source line S, and a control voltage (e.g. +25V) is provided by the control line C. Consequently, during the electrons are transmitted from the source line S to the drain line D through an n-channel region, the hot carriers (e.g. hot electrons) are attracted by the control voltage on the control gate 12 and injected into the floating gate 14. Under this circumstance, a great number of carriers are accumulated in the floating gate 14. Consequently, the programmed state may be considered as a first storage state (e.g. "0").

In a case that the nonvolatile memory is in a non-programmed state, no carrier is injected into the floating gate 14, and thus the non-programmed state may be considered as a second storage state (e.g. "1").

In other words, the characteristic curves of the drain current (id) and the gate-source voltage (Vgs) (i.e. an id-Vgs characteristic curve) in the first storage state and the id-Vgs characteristic curve in the second storage state are distinguished. Consequently, the storage state of the floating-gate transistor may be realized according to the variation of the id-Vgs characteristic curve.

However, since the floating gate 14 and the control gate 12 of the programmable dual-poly nonvolatile memory should be separately produced, the process of fabricating the programmable dual-poly nonvolatile memory needs more steps and is incompatible with the standard CMOS manufacturing process.

US patent No. 6678190 discloses a programmable single-poly nonvolatile memory. FIG. 2A is a schematic cross-sectional view illustrating a conventional programmable single-poly nonvolatile memory disclosed in US patent No. 6678190. FIG. 2B is a schematic top view illustrating the conventional programmable single-poly nonvolatile memory of FIG. 2A. FIG. 2C is a schematic circuit diagram illustrating the conventional programmable single-poly nonvolatile memory of FIG. 2A.

Please refer to FIGS. 2A-2C. The conventional programmable single-poly nonvolatile memory comprises two serially-connected p-type metal-oxide semiconductor (PMOS) transistors. The first PMOS transistor is used as a select transistor, and a select gate 24 of the first PMOS transistor is connected to a select gate voltage V_{SG}. A first source/drain region 21 is connected to a source line voltage V_{SL}. Moreover, a second source/drain region 22 may be considered as a combination of a p-type drain region of the first PMOS transistor and a p-type source region of the second PMOS transistor. A floating gate 26 is disposed over the second PMOS transistor. A third source/drain region 23 of the second PMOS transistor is connected to a bit line voltage V_{BL}. Moreover, these PMOS transistors are constructed in an N-well region (NW). The N-well region is connected to an N-well voltage V_{NW}.

By properly controlling the select gate voltage V_{SG}, the source line voltage V_{SL}, the bit line voltage V_{BL} and the N-well voltage V_{NW}, the conventional programmable single-poly nonvolatile memory may be operated in a programmed state or a read state.

Since the two PMOS transistors of the conventional programmable single-poly nonvolatile memory have respective gates 24 and 26, the process of fabricating the conventional programmable single-poly nonvolatile memory is compatible with the standard CMOS manufacturing process.

As described in FIGS. 1 and 2, the nonvolatile memory is programmable. The electrical property of the nonvolatile memory is only utilized to inject a great number of hot carriers to the floating gate. However, the electrical property fails to be utilized to remove the carriers from the floating gate. That is, for achieving the data-erasing function, the carriers stored in the floating gate may be removed from the floating gate by exposing ultraviolet (UV) light to the nonvolatile memory. These nonvolatile memories are named as one time programming (OTP) memories.

The American patent application US 2010/0149874 A1 discloses an erasable non-volatile memory cell with a deep N-well located in the P substrate, while a P-well and an N-well are located in the deep N-well. The memory cell includes a PMOS transistor located in the N-well, in which the PMOS transistor includes a PMOS gate-oxide, and an NMOS capacitor located in the P-well. The NMOS capacitor includes an N+ coupling region located in the P-well, and an NMOS gate-oxide. The memory cell includes a floating gate comprised of a poly-silicon gate overlying the PMOS transistor and the NMOS capacitor.

The American patent application US 2010/0157669 A1 discloses a non-volatile memory (NVM) cell and an array including a control capacitor, tunneling capacitor, CMOS inverter and output circuit. The CMOS inverter includes PMOS and NMOS inverter transistors. The control capacitor, tunneling capacitor and PMOS and NMOS inverter transistors share a common floating gate, which is programmed and erased by Fowler-Nordheim tunneling. The output circuit includes PMOS and NMOS select transistors. The PMOS inverter and select transistors share a common source/drain region. Similarly, the NMOS inverter and select transistors share a common source/drain region.

Therefore, for multi-times programming (MTP) memories design, there is a need of providing an erasable programmable single-poly nonvolatile memory.

### SUMMARY OF THE INVENTION

The problem of the present invention is solved for an erasable programmable single-poly nonvolatile according to the preamble of claim 1 by the combination of features according to the characterizing part of claim 1.

Numerous objects, features and advantages of the present invention will be readily apparent upon a reading of the following detailed description of embodiments of the present invention when taken in conjunction with the accompanying drawings. However, the drawings employed herein are for the purpose of descriptions and should not be regarded as limiting.

### BRIEF DESCRIPTION OF THE DRAWINGS

The above objects and advantages of the present invention will become more readily apparent to those ordinarily skilled in the art after reviewing the following detailed description and accompanying drawings, in which:
FIG. 1 (prior art) is a schematic cross-sectional view illustrating a conventional programmable dual-poly nonvolatile memory;
FIG. 2A (prior art) is a schematic cross-sectional view illustrating a conventional programmable single-poly nonvolatile memory disclosed in US patent No. 6678190;
FIG. 2B (prior art) is a schematic top view illustrating the conventional programmable single-poly nonvolatile memory of FIG. 2A;
FIG. 2C (prior art) is a schematic circuit diagram illustrating the conventional programmable single-poly nonvolatile memory of FIG. 2A;
FIGS. 3A∼3D schematically illustrate an erasable programmable single-poly nonvolatile memory according to a first example not forming part of the present invention;
FIGS. 4∼6 schematically illustrate different substrate structures and P-well region (PW) applied to the first example;
FIGS. 7A∼7C schematically illustrate an erasable programmable single-poly nonvolatile memory according to a second example not forming part of the present invention;
FIGS. 8∼9 schematically illustrate different substrate structures and P-well region (PW) according to an embodiment of the present invention; and
FIG. 10 shows two voltage biasing methods in erased state.

### DETAILED DESCRIPTION OF PREFERRED EMBODIMENTS

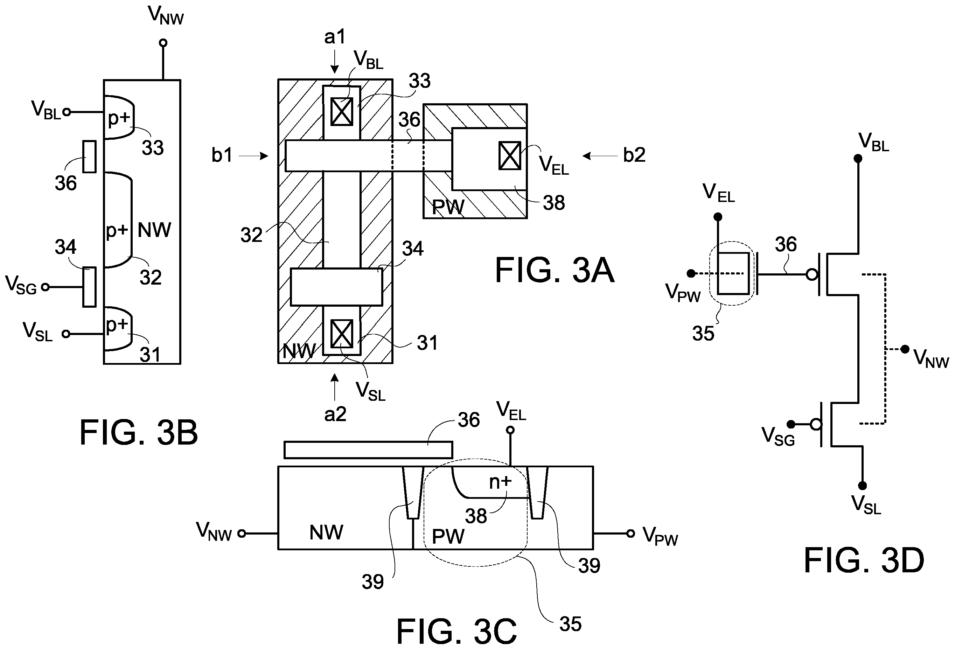

FIGS. 3A∼3D schematically illustrate an erasable programmable single-poly nonvolatile memory according to a first example not forming part of the present invention. FIG. 3A is a schematic top view illustrating the erasable programmable single-poly nonvolatile memory according to the first example. FIG. 3B is a schematic cross-sectional view illustrating the erasable programmable single-poly nonvolatile memory of FIG. 3A and taken along a first direction (a1-a2). FIG. 3C is a schematic cross-sectional view illustrating the erasable programmable single-poly nonvolatile memory of FIG. 3A and taken along a second direction (b1-b2). FIG. 3D is a schematic equivalent circuit diagram of the erasable programmable single-poly nonvolatile memory according to the first example.

As shown in FIGS. 3A and 3B, the erasable programmable single-poly nonvolatile memory of the first example comprises two serially-connected p-type metal-oxide semiconductor (PMOS) transistors. These two PMOS transistors are constructed in an N-well region (NW). Three source/drain regions 31, 32 and 33 are formed in the N-well region (NW). In addition, two polysilicon gates 34 and 36 are spanned over the areas between the three source/drain regions 31, 32 and 33.

The first PMOS transistor is used as a select transistor, and the polysilicon gate 34 (also referred as a select gate) of the first PMOS transistor is connected to a select gate voltage V_{SG}. The first source/drain region 31 is a p-type source region and connected to a source line voltage V_{SL}. The second source/drain region 32 is a p-type drain region, which may be considered as a combination of the p-type drain region of the first PMOS transistor and a p-type source region of the second PMOS transistor. The polysilicon gate 36 (also referred as a floating gate) is disposed over the second PMOS transistor. The third source/drain region 33 is a p-type drain region of the second PMOS transistor and connected to a bit line voltage V_{BL}. Moreover, the N-well region (NW) is connected to an N-well voltage V_{NW}.

Generally, during the ion implantation processes of forming the source/drain regions 31, 32 and 33, the floating gate 36 and the select gate 34 are used as the implantation mask layers. Consequently, the floating gate 36 and the select gate 34 over the N-well region (NW) are p-type gates.

As shown in FIGS. 3A and 3C, the erasable programmable single-poly nonvolatile memory of the first example comprises an n-type metal-oxide semiconductor (NMOS) transistor or a combination of the floating gate 36 and an erase gate region 35. The NMOS transistor is constructed in a P-well region (PW). An n-type source/drain region 38 is formed in the P-well region (PW). In other words, the erase gate region 35 includes the P-well region (PW) and the n-type source/drain regions 38.

As shown in FIG. 3A, the floating gate 36 is extended to and is adjacent to the erase gate region 35. Moreover, the n-type source/drain region 38 may be considered as a combination of an n-type source region and an n-type drain region of the NMOS transistor and the floating gate 36 may be considered as a gate of the NMOS transistor. The n-type source/drain region 38 is connected to an erase line voltage V_{EL}. In addition, the P-well region (PW) is connected to a P-well voltage V_{PW}. As shown in FIG. 3C, an isolation structure 39 is formed between the P-well region (PW) and the N-well region (NW). For example, the isolation structure 39 is a shallow trench isolation (STI) structure.

During the ion implantation process of forming the n-type source/drain region 38, the floating gate 36 is used as the implantation mask layer. Consequently, the floating gate 36 over the erase gate region 35 is an n-type gate.

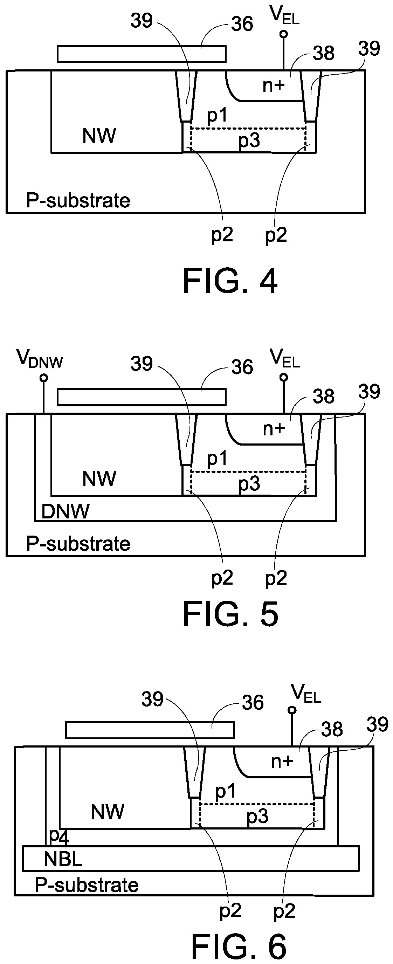

Furthermore, different substrate structures and P-well region (PW) applied to the first example will be illustrated in more details as follows. As shown in FIG. 4, the substrate structure is a P-substrate.

The N-well region (NW) and the P-well region (PW) of the first example are formed in the P-substrate. The P-well region (PW) further comprises a first p-type region (p1), two second p-type regions (p2), and a third p-type region (p3). The dosage in the second p-type region (p2) is higher than or equal to the dosage in the first p-type region (p1). Also, the dosage in the third p-type region (p3) is higher than or equal to the dosage in the first p-type region (p1).

In addition, the first p-type region (p1) is formed under the surface of the P-substrate and contacted to the n-type source/drain region 38; and the third p-type region (p3) is formed under the first p-type region (p1). Furthermore, the first p-type region (p1) and the third p-type region (p3) are located between the two second p-type regions (p2), which are formed under the two isolation structures 39.

According to FIG. 4, the junction breakdown voltage between the n-type source/drain region 38 and the first p-type region (p1) is increased and thus the erase efficiency of the erasable programmable single-poly nonvolatile memory is improved.

As shown in FIG. 5, the substrate structure includes a deep N-well region (DNW) and a P-substrate. The deep N-well region (DNW) is formed in the P-substrate and the deep N-well region (DNW) is connected to a deep N-well voltage V_{DNW}.

The N-well region (NW) and the P-well region (PW) of the first example are formed in the deep N-well region (DNW) of the substrate structure. The P-well region (PW) further comprises a first p-type region (p1), two second p-type regions (p2), and a third p-type region (p3). The dosage in the second p-type region (p2) is higher than or equal to the dosage in the first p-type region (p1). Also, the dosage in the third p-type region (p3) is higher than or equal to the dosage in the first p-type region (p1).

In addition, the first p-type region (p1) is formed under the surface of the substrate structure and contacted to the n-type source/drain region 38; and the third p-type region (p3) is formed under the first p-type region (p1). Furthermore, the first p-type region (p1) and the third p-type region (p3) are located between the two second p-type regions (p2), which are formed under the two isolation structures 39.

According to FIG. 5, the junction breakdown voltage between the n-type source/drain region 38 and the first p-type region (p1) is increased and thus the erase efficiency of the erasable programmable single-poly nonvolatile memory is improved. Furthermore, the two second p-type regions (p2) are capable of improving the lateral punch through effect between the n-type source/drain region 38 and the N-well region (NW) ; and the third p-type region (p3) is capable of improving the vertical punch through effect between the n-type source/drain region 38 and the deep N-well region (DNW), especially in the high temperature environment.

As shown in FIG. 6, the substrate structure includes a fourth p-type region (p4), an n-type barrier layer (NBL, i.e. a second n-type region), and a P-substrate. The n-type barrier layer (NBL) is formed in the P-substrate, and the fourth p-type region (p4) is formed above and contacted to the n-type barrier layer (NBL).

The N-well region (NW) and the P-well region (PW) of the first example are formed in the fourth p-type region (p4) of the substrate structure. The P-well region (PW) further comprises a first p-type region (p1), two second p-type regions (p2), and a third p-type region (p3). The dosage in the second p-type region (p2) is higher than or equal to the dosage in the first p-type region (p1). Also, the dosage in the third p-type region (p3) is higher than or equal to the dosage in the first p-type region (p1). In addition, the dosage in the fourth p-type region (p4) is equal to the dosage in the P-substrate. Or, the dosage in the fourth p-type region (p4) is higher than or equal to the dosage in the third p-type region (p3) and the dosage in the fourth p-type region (p4) is lower than or equal to the dosage in the second p-type region (p2).

In addition, the first p-type region (p1) is formed under the surface of the substrate structure and contacted to the n-type source/drain region 38; and the third p-type region (p3) is formed under the first p-type region (p1). Furthermore, the first p-type region (p1) and the third p-type region (p3) are located between the two second p-type regions (p2), which are formed under the two isolation structures 39.

According to FIG. 6, the junction breakdown voltage between the n-type source/drain region 38 and the first p-type region (p1) is increased and thus the erase efficiency of the erasable programmable single-poly nonvolatile memory is improved. Furthermore, the second p-type regions (p2) are capable of improving the lateral punch through effect between the n-type source/drain region 38 and the N-well region (NW) at higher temperature; and the third p-type region (p3) is capable of improving the vertical punch through effect between the n-type source/drain region 38 and the n-type barrier layer (NBL) at higher temperature. Also, the N-well region (NW) of the first example is isolated by the fourth p-type region (p4) and the P-well region (PW), thus the independent bias voltage is capable of reducing the voltage stress between the floating gate 36 and the N-well region (NW).

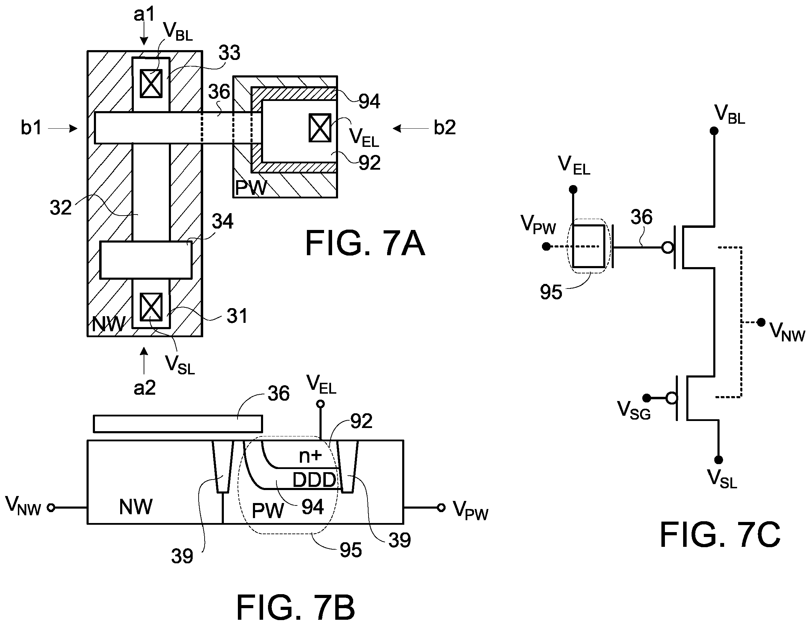

FIGS. 7A∼7C schematically illustrate an erasable programmable single-poly nonvolatile memory according to a second example not forming part of the present invention. FIG. 7A is a schematic top view illustrating the erasable programmable single-poly nonvolatile memory according to the second example. FIG. 7B is a schematic cross-sectional view illustrating the erasable programmable single-poly nonvolatile memory of FIG. 7A and taken along the second direction (b1-b2). FIG. 7C is a schematic equivalent circuit diagram of the erasable programmable single-poly nonvolatile memory according to the second example. The cross-sectional view of the erasable programmable single-poly nonvolatile memory of this example along the first direction (a1-a2) is similar to that of the first example, and is not redundantly shown.

As shown in FIG. 7A, the erasable programmable single-poly nonvolatile memory of the second example comprises two serially-connected p-type metal-oxide semiconductor (PMOS) transistors. These two PMOS transistors are constructed in an N-well region (NW). Three source/drain regions 31, 32 and 33 are formed in the N-well region (NW). In addition, two polysilicon gates 34 and 36 are spanned over the areas between the three source/drain regions 31, 32 and 33.

The first PMOS transistor is used as a select transistor, and the polysilicon gate 34 (also referred as a select gate) of the first PMOS transistor is connected to a select gate voltage V_{SG}. The first source/drain region 31 is a p-type source region and connected to a source line voltage V_{SL}. The second source/drain region 32 is a p-type drain region, which may be considered as a combination of the p-type drain region of the first PMOS transistor and a p-type source region of the second PMOS transistor. The polysilicon gate 36 (also referred as a floating gate) is disposed over the second PMOS transistor. The third source/drain region 33 is a p-type drain region of the second PMOS transistor and connected to a bit line voltage V_{BL}. Moreover, the N-well region (NW) is connected to an N-well voltage V_{NW}.

As shown in FIGS. 7A and 7B, the erasable programmable single-poly nonvolatile memory of the second example comprises an n-type metal-oxide semiconductor (NMOS) transistor constructed in a P-well region (PW). The NMOS transistor also can be seen as a combination of the floating gate 36 and an erase gate region 95. In other words, the erase gate region 95 includes the P-well region (PW), the n-type source/drain regions 92 and a double diffused drain (DDD) region 94 (i.e. a first n-type region (n1)). In addition, the n-type source/drain region 92 and the double diffused drain (DDD) region 94 are formed in the P-well region (PW). The n-type source/drain region 92 is formed in the double diffused drain (DDD) region 94. In addition, after manufacturing the DDD region 94, the defined mask pattern of manufacturing DDD region 94 is able to be used for etching the gate oxide above the erase gate region 95. That is to say, thickness of the gate oxide above the erase gate region 95 is thinner than the gate oxide under the floating gate 36. In this way, the erase line voltage V_{EL} can be smaller in the typical erased state.

As shown in FIG. 7A, the floating gate 36 is extended to and is adjacent to the erase gate region 95. Moreover, the double diffused drain (DDD) region 94 and the n-type source/drain region 92 may be considered as a combination of an n-type source region and an n-type drain region. The P-well region (PW) is connected to a P-well voltage V_{PW}. As shown in FIG. 7B, an isolation structure 39 is formed between the P-well region (PW) and the N-well region (NW).

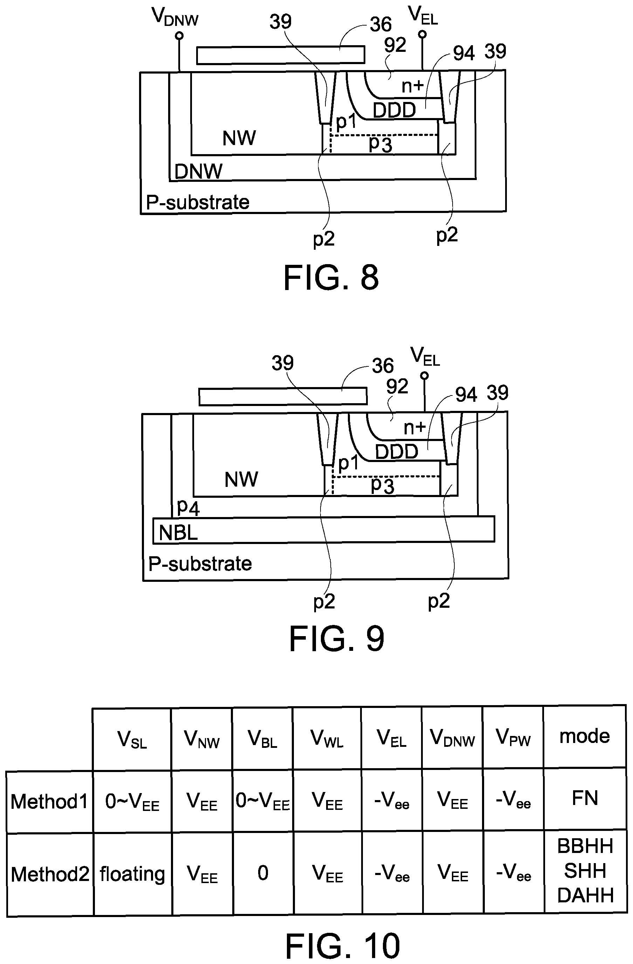

Furthermore, different substrate structures and P-well region (PW) according to an embodiment of the present invention will be illustrated in more details as follows. As shown in FIG. 8, the substrate structure in an embodiment according to the present invention includes a deep N-well region (DNW), and a P-substrate. The deep N-well region (DNW) is formed in the P-substrate and the deep N-well region (DNW) is connected to a deep N-well voltage V_{DNW}.

The N-well region (NW) and the P-well region (PW) of the embodiment are formed in the substrate structure. Furthermore, the P-well region (PW) further comprises a first p-type region (p1), two second p-type regions (p2), and a third p-type region (p3). The dosage in the second p-type regions (p2) is higher than the dosage in the first p-type region (p1). The dosage in the third p-type region (p3) is higher than the dosage in the first p-type region (p1). The dosage in the N-well region (NW) is higher than or equal to the dosage in the double diffused drain (DDD) region 94. Also, the dosage in the first p-type region (p1) is higher than or equal to the dosage in the double diffused drain (DDD) region 94.

In addition, the first p-type region (p1) is formed under the surface of the substrate structure and contacted to the double diffused drain (DDD) region 94; and the third p-type region (p3) is formed under the first p-type region (p1). Furthermore, the second p-type regions (p2) are formed under the isolation structures 39 and contacted to the first p-type region (p1) and the third p-type region (p3).

According to FIG. 8 of the present invention, the junction breakdown voltage between the double diffused drain (DDD) region 94 (i.e. the first n-type region (n1)) and the first p-type region (p1) is increased and thus the erase efficiency of the erasable programmable single-poly nonvolatile memory is improved. Furthermore, the second p-type region (p2) is capable of improving the lateral punch through effect between the double diffused drain (DDD) region 94 and the N-well region (NW) at higher temperature; and the third p-type region (p3) is capable of improving the vertical punch through effect between the double diffused drain (DDD) region 94 and the deep N-well region (DNW) at higher temperature.

As shown in FIG. 9, the substrate structure includes a fourth p-type region (p4), an n-type barrier layer (NBL, i.e. a second n-type region), and a P-substrate. The n-type barrier layer (NBL) is formed in the substrate structure, and the fourth p-type region (p4) is formed above and contacted to the n-type barrier layer (NBL).

The N-well region (NW) and the P-well region (PW) of the embodiment are formed in the substrate structure. Furthermore, the P-well region (PW) further comprises a first p-type region (p1), two second p-type regions (p2), and a third p-type region (p3). The dosage in the second p-type region (p2) is higher than the dosage in the first p-type region (p1). Also, the dosage in the third p-type region (p3) is higher than the dosage in the first p-type region (p1). In addition, the dosage in the fourth p-type region (p4) is equal to the dosage in the P-substrate. Or, the dosage in the fourth p-type region (p4) is higher than or equal to the dosage in the third p-type region (p3) and the dosage in the fourth p-type region (p4) is lower than or equal to the dosage in the second p-type region (p2).

In addition, the first p-type region (p1) is formed under the surface of the substrate structure and contacted to the double diffused drain (DDD) region 94 and the third p-type region (p3) is formed under the first p-type region (p1). Furthermore, the second p-type regions (p2) are formed under the isolation structures 39 and contacted to the first p-type region (p1) and the third p-type region (p3).

According to FIG. 9 of the present invention, the junction breakdown voltage between the double diffused drain (DDD) region 94 (i.e. the first n-type region (n1)) and the first p-type region (p1) is increased and thus the erase efficiency of the erasable programmable single-poly nonvolatile memory is improved. Furthermore, the second p-type region (p2) is capable of improving the lateral punch through effect between the double diffused drain (DDD) region 94 and the N-well region (NW) at higher temperature; and the third p-type region (p3) is capable of improving the vertical punch through effect between the double diffused drain (DDD) region 94 and the n-type barrier layer (NBL) at higher temperature. Also, the N-well region (NW) of the embodiment is isolated by the fourth p-type region (p4) and the P-well region (PW), thus the independent bias voltage is capable of reducing the voltage stress between the floating gate 36 and the N-well region (NW).

According to the present invention, some biasing voltages may provide to the first example and to the embodiment constructed in the deep N-well region (DNW) of the substrate structure as shown in FIGS. 5 and 8 in the erased state. FIG. 10 shows two voltage biasing methods in erased state. As shown in FIG. 10, when the first method is used in the erased state, the source line voltage V_{SL} and the bit line voltage is in a range between 0V to a positive voltage V_{EE}, the N-well voltage V_{NW} and the word line voltage V_{WL} and the deep N-well voltage V_{DNW} is equal to the positive voltage (V_{EE}). Whereas, the erase line voltage V_{EL} and the P-well voltage V_{PW} is equal to a negative voltage -Vₑₑ. The positive voltage V_{EE} is in the range between +6.5V and +18V and the negative voltage -Vₑₑ is in the range between -6.5V and -18V. In this way, the ejection of the storage carriers can be achieved by using Fowler-Nordheim (FN) effect.

**As** shown in FIG. 10, when the second method is used in the erased state, the source line voltage V_{SL} is floating, and the bit line voltage is in a ground voltage (0V), and the N-well voltage V_{NW} and the word line voltage V_{WL} and the deep N-well voltage V_{DNW} is equal to the positive voltage (V_{EE}). Whereas, the erase line voltage V_{EL} and the P-well voltage V_{PW} is equal to a negative voltage -Vₑₑ. The positive voltage V_{EE} is in the range between +6.5V and +18V and the negative voltage -Vₑₑ is in the range between -6.5V and -18V. In this way, the ejection of the storage carriers can be achieved by using Hot Hole (HH) effect, such as, band-to-band hot hole (BBHH) effect, substrate hot hole (SHH) effect, and drain avalanche hot hole (DAHH) effect.

From the above description, the erasable programmable single-poly nonvolatile memory of the present invention is capable of solving the drawbacks of using ultraviolet light to remove hot carriers. That is, by providing the erase line voltage V_{EL}, storage state of the nonvolatile memory of the present invention is changeable.

## Claims

1. An erasable programmable single-poly nonvolatile memory, comprising:
a substrate structure (P-substrate);
a first PMOS transistor comprising a select gate (34), a first source/drain region (31), and a second source/drain region (32), wherein the select gate (34) is connected to a select gate voltage (V_{SG}), and the first source/drain region (31) is connected to a source line voltage (V_{SL});
a second PMOS transistor comprising the second source/drain region (32), a third source/drain region (33), and a floating gate (36), wherein the third source/drain region (33) is connected to a bit line voltage (V_{BL}), and the first source/drain region (31), the second source/drain region (32), and the third source/drain region (33) are constructed in a N-well region (NW); and
an erase gate region (95), wherein said floating gate (36) extends over said erase gate region (95) and wherein the erase gate region (95) comprises an n-type source/drain region (92) connected to an erase line voltage (V_{EL}) and a P-well region (PW);
wherein the N-well region (NW) and the P-well region (PW) are formed in the substrate structure;
**characterized in that**
the erase gate region (95) further comprises a first n-type double diffused drain region (94) formed between the n-type source/drain region (92) and the P-well region (PW), wherein the P-well region (PW) comprises: a first p-type region (p1) formed under a surface of the substrate structure and contacted to the first n-type double diffused drain region (94); a plurality of second p-type regions (p2); and a third p-type region (p3) formed under the first p-type region (p1);
wherein the first p-type region (p1) and the third p-type region (p3) are located between the second p-type regions (p2); and
wherein a dosage in the second p-type regions (p2) is higher than a dosage in the first p-type region (p1), and a dosage in the third p-type region (p3) is higher than the dosage in the first p-type region (p1).

2. The erasable programmable single-poly nonvolatile memory as claimed in claim 1, wherein the substrate structure comprises:
a P-substrate; and
a deep N-well region (DNW) formed in the P-substrate, wherein the deep N-well region (DNW) is contacted to the N-well region (NW), the second p-type regions (p2) and the third p-type region (p3), and the deep N-well region (DNW) is connected to a deep N-well voltage (V_{DNW}).

3. The erasable programmable single-poly nonvolatile memory as claimed in claim 1, wherein the substrate structure comprises:
a P-substrate;
a second n-type region (NBL) formed in the P-substrate; and
a fourth p-type region (p4) formed above and contacted to the second n-type region (NBL), wherein the fourth p-type region (p4) is contacted to the N-well region (NW), the second p-type regions (p2) and the third p-type region (p3).

4. The erasable programmable single-poly nonvolatile memory as claimed in claim 3, wherein a dosage in the fourth p-type region (p4) is higher than or equal to a dosage in the P-substrate, a dosage in the fourth p-type region (p4) is higher than or equal to a dosage in the third p-type region (p3), and the dosage in the fourth p-type region (p4) is lower than or equal to a dosage in the second p-type region (p2).

## Patentansprüche

1. Löschbarer programmierbarer nichtflüchtiger Einzelpolyspeicher, welcher aufweist:
eine Substratstruktur (P-Substrat),
einen ersten PMOS-Transistor, der ein Auswahlgatter (34), einen ersten Quellen-/Senkenbereich (31) und einem zweiten Quellen-/Senkenbereich (32) aufweist, wobei das Auswahlgatter (34) mit einer Auswahlgatterspannung (V_{SG}) verbunden ist und der erste Quellen-/Senkenbereich (31) mit einer Quellenleitungsspannung (V_{SL}) verbunden ist,
einen zweiten PMOS-Transistor, der den zweiten Quellen-/Senkenbereich (32), einen dritten Quellen-/Senkenbereich (33) und ein schwebendes Gatter (36) aufweist, wobei der dritte Quellen-/Senkenbereich (33) mit einer Bitleitungsspannung (V_{BL}) verbunden ist und der erste Quellen-/Senkenbereich (31), der zweite Quellen-/ Senkenbereich (32) und der dritte Quellen-/Senkenbereich (33) in einem Bereich (NW) einer N-Wanne gebildet worden sind, und
einen Lösch-Gatter-Bereich (95), wobei sich das schwebende Gatter (36) über den Lösch-Gatter-Bereich (95) erstreckt und wobei der Lösch-Gatter-Bereich (95) einen Quellen-/Senkenbereich (92) vom Typ n aufweist, der mit einer Löschleitungsspannung (V_{E}L) und einem Bereich (PW) einer P-Wanne verbunden ist,
wobei der Bereich (NW) der N-Wanne und der Bereich (PW) der P-Wanne in der Substratstruktur gebildet worden sind,
**dadurch gekennzeichnet, dass** der Lösch-Gatter-Bereich (95) ferner einen ersten doppelt diffundierten Senken-Bereich (94) vom Typ n aufweist, der zwischen dem Quellen-/Senkenbereich (92) vom Typ n und dem Bereich (PW) der P-Wanne gebildet worden ist, wobei der Bereich (PW) der P-Wanne einen ersten Bereich (p1) vom Typ p, der unter einer Oberfläche der Substratstruktur gebildet worden ist und der mit dem ersten doppelt diffundierten Senken-Bereich (94) vom Typ n in Kontakt gebracht worden ist, eine Vielzahl an zweiten Bereichen (p2) vom Typ p, und einen dritten Bereich (p3) vom Typ p aufweist, der unter dem ersten p-Typ-Bereich (p1) gebildet worden ist,
wobei sich der erste Bereich (p1) vom Typ p und der dritte Bereich (p3) vom Typ p zwischen den zweiten Bereichen (p2) vom Typ p befinden, und
wobei eine Dotierung in den zweiten Bereichen (p2) vom Typ p höher als eine Dotierung in dem ersten Bereich (p1) vom Typ p ist und eine Dotierung in dem dritten Bereich (p3) vom Typ p höher als die Dotierung in dem ersten Bereich (p1) vom Typ p ist.

2. Löschbarer programmierbarer nichtflüchtiger Einzelpolyspeicher nach Anspruch 1, wobei die Substratstruktur aufweist:
ein P-Substrat, und
einen Bereich (DNW) einer tiefen N-Wanne, der in dem P-Substrat gebildet worden ist, wobei der Bereich (DNW) der tiefen N-Wanne mit dem Bereich (NW) der N-Wanne, den zweiten Bereichen (p2) vom Typ p und dem dritten Bereich (p3) vom Typ p kontaktiert ist und der Bereich (DNW) der tiefen N-Wanne mit einer Spannung (V_{DNW}) der tiefen N-Wanne verbunden sind.

3. Löschbarer programmierbarer nichtflüchtiger Einzelpolyspeicher nach Anspruch 1, wobei die Substratstruktur aufweist:
ein P-Substrat,
einen zweiten Bereich (NBL) vom Typ n, der in dem P-Substrat gebildet worden ist, und
einen vierten Bereich (p4) vom Typ p, der oben gebildet worden ist und der mit dem zweiten Bereich (NBL) vom Typ n in Kontakt gebracht ist, wobei der vierte Bereich (p4) vom Typ p mit dem Bereich (NW) der N-Wanne, den zweiten Bereichen (p2) vom Typ p und dem dritten Bereich (p3) vom Typ p in Kontakt gebracht ist.

4. Löschbarer programmierbarer nichtflüchtiger Einzelpolyspeicher nach Anspruch 3, wobei eine Dotierung in dem vierten Bereich (p4) vom Typ p höher eine als oder gleich einer Dotierung in dem P-Substrat ist, eine Dotierung in dem vierten Bereich (p4) vom Typ p höher als eine oder gleich einer Dotierung in dem dritten Bereich (p3) vom Typ p ist und die Dotierung in dem vierten Bereich (p4) vom Typ p niedriger als eine oder gleich einer Dotierung in dem zweiten Bereich (p2) vom Typ p ist.

## Revendications

1. Mémoire non volatile de type single poly effaçable et programmable, comprenant :
une structure de substrat (substrat P) ;
un premier transistor PMOS comprenant une grille de sélection (34), une première région de source/drain (31), et une deuxième région de source/drain (32), dans laquelle la grille de sélection (34) est connectée à une tension de grille de sélection (V_{SG}), et la première région de source/drain (31) est connectée à une tension de ligne de source (V_{SL}) ;
un second transistor PMOS comprenant la deuxième région de source/drain (32), une troisième région de source/drain (33), et une grille flottante (36), dans laquelle la troisième région de source/drain (33) est connectée à une tension de ligne de bit (V_{BL}), et la première région de source/drain (31), la deuxième région de source/drain (32), et la troisième région de source/drain (33) sont construites dans une région de puits N (NW) ; et
une région de grille d'effacement (95), dans laquelle ladite grille flottante (36) s'étend sur ladite région de grille d'effacement (95) et dans laquelle la région de grille d'effacement (95) comprend une région de source/drain de type n (92) connectée à une tension de ligne d'effacement (V_{EL}) et une région de puits P (PW) ;
dans laquelle la région de puits N (NW) et la région de puits P (PW) sont formées dans la structure de substrat ;
**caractérisée en ce que**
la région de grille d'effacement (95) comprend en outre une première région de drain à double diffusion de type n (94) formée entre la région de source/drain de type n (92) et la région de puits P (PW), dans laquelle la région de puits P (PW) comprend : une première région de type p (p1) formée sous une surface de la structure de substrat et mise en contact avec la première région de drain à double diffusion de type n (94) ; une pluralité de deuxièmes régions de type p (p2) ; et une troisième région de type p (p3) formée sous la première région de type p (p1) ;
dans laquelle la première région de type p (p1) et la troisième région de type p (p3) sont situées entre les deuxièmes régions de type p (p2) ; et
dans laquelle un dosage dans les deuxièmes régions de type p (p2) est plus élevé qu'un dosage dans la première région de type p (p1), et un dosage dans la troisième région de type p (p3) est plus élevé que le dosage dans la première région de type p (p1).

2. Mémoire non volatile de type single poly effaçable et programmable selon la revendication 1, dans laquelle la structure de substrat comprend :
un substrat P ; et
une région de puits N profond (DNW) formée dans le substrat P, dans laquelle la région de puits N profond (DNW) est mise en contact avec la région de puits N (NW), les deuxièmes régions de type p (p2) et la troisième région de type p (p3), et la région de puits N profond (DNW) est connectée à une tension de puits N profond (V_{DNW}).

3. Mémoire non volatile de type single poly effaçable et programmable selon la revendication 1, dans laquelle la structure de substrat comprend :
un substrat P ;
une deuxième région de type n (NBL) formée dans le substrat P ; et
une quatrième région de type p (p4) formée au-dessus de et mise en contact avec la deuxième région de type n (NBL),
dans laquelle la quatrième région de type p (p4) est mise en contact avec la région de puits N (NW), les deuxièmes régions de type p (p2) et la troisième région de type p (p3).

4. Mémoire non volatile de type single poly effaçable et programmable selon la revendication 3, dans laquelle un dosage dans la quatrième région de type p (p4) est plus élevé que ou égal à un dosage dans le substrat P, un dosage dans la quatrième région de type p (p4) est plus élevé que ou égal à un dosage dans la troisième région de type p (p3), et le dosage dans la quatrième région de type p (p4) est plus petit que ou égal à un dosage dans la deuxième région de type p (p2).
